Europäisches Patentamt

European Patent Office

Office européen des brevets

(19)

(11) Veröffentlichungsnummer: **0 073 885**
A2

# (12) EUROPÄISCHE PATENTANMELDUNG

(21) Anmeldenummer: 82105453.3

(22) Anmeldetag: 22.06.82

(51) Int. Cl.³: **H 03 L 7/08**
H 03 F 3/19, H 03 F 1/42

(30) Priorität: 04.09.81 DE 3135000

(43) Veröffentlichungstag der Anmeldung:
16.03.83 Patentblatt 83/11

(84) Benannte Vertragsstaaten:
AT BE DE FR GB IT LU NL

(71) Anmelder: Licentia Patent-Verwaltungs-GmbH
Theodor-Stern-Kai 1
D-6000 Frankfurt/Main 70(DE)

(72) Erfinder: Burkert, Edgar, Dipl.-Ing.
Mozartstrasse 17
D-7153 Weissach im Tal(DE)

(72) Erfinder: Brauns, Herbert, Ing. grad.
Königsberger Strasse 2
D-7150 Backnang(DE)

(74) Vertreter: Schickle, Gerhard, Dipl.-Ing. et al,
Licentia Patent-Verwaltungs-GmbH Theodor-Stern-Kai
1
D-6000 Frankfurt/Main 70(DE)

(54) Regelverstärker für einen Phasenregelkreis.

(57) Die vorliegende Erfindung betrifft einen Regelverstärker innerhalb eines Phasenregelkreises (PLL).

Um unabhängig voneinander das Gleichspannungs- bzw. Niederspannungssignal und das Hochfrequenzsignal in einem gewünschten optimalen Maß verstärken zu können, ist der Regelverstärker aus der Parallelschaltung eines Niederfrequenzverstärkers (NFV) und eines Hochfrequenzverstärkers (HFV) gebildet.

FIG.2

EP 0 073 885 A2

- 2 -

Licentia Patent-Verwaltungs-GmbH      Z13 PTL-BK/Th/ma
Theodor-Stern-Kai 1                 BK 81/93
D-6000 Frankfurt 70

Regelverstärker für einen Phasenregelkreis

Die vorliegende Erfindung betrifft einen Regelverstärker, der innerhalb eines Phasenregelkreises (PLL) zwischen den Phasendetektor und den spannungsgesteuerten Oszillator geschaltet ist.

Der im folgenden behandelte Phasenregelkreis hat einen wesentlich größeren statischen Haltebereich (Synchronisationsbereich) als dynamischen Übertragungsbereich. Dies bedeutet, daß der dem spannungsgesteuerten Oszialltor vorgeschaltete Regelverstärker eine wesentlich höhere Verstärkung des Gleichspannungs- bzw. Niederfrequenzsignals (ca. 0 ./. 10 kHz) als des Hochfrequenzsignals (ca. 0,5 ./. 100 MHz) aufweisen muß. Für solche Zwecke ist aus K. E. Schertler, "Microwave Power Up-Converters for Angle Modulated Signals Using Phase-Locked Microwave Oscillators", 5th E.M.C. Hamburg, pp. 195 bis 199, ein Regelverstärker bekannt, der, um die geforderte hohe Verstärkung des niederfrequenten Signals zu erreichen, aus mehreren Verstärkerstufen besteht. Dieser Regelverstärker verstärkt das Hochfrequenz- und das Gleich-

0073885

BK 81/93

spannungs- bzw. Niederfrequenzsignal in gleichem Maße, obwohl für das Hochfrequenzsignal eine wesentlich niedrigere Verstärkung gefordert ist. Es ist hierbei nicht möglich, die Niederfrequenzsignal-Verstärkung und die Hochfrequenzsignal-Verstärkung unabhängig voneinander einzustellen.

Die Verstärkung des Hochfrequenzsignals über mehrere Stufen verursacht störende Phasendrehungen, die zu Beschränkungen der Übertragungsbandbreite des PLL führen.

Außerdem ist die Forderung nach einem kleinen Innenwiderstand des mehrstufigen Regelverstärkers für hohe Frequenzen nur mit großem Aufwand zu erreichen. Denn ein großer Innenwiderstand im Zusammenhang mit der den Regelverstärker abschließenden, durch den spannungsgesteuerten Oszillator gegebenen Kapazität führt zu einer erheblichen Phasendrehung, was zu Laufzeitverzerrungen des zu übertragenden Signals oder zur Instabilität des PLL führen kann.

Aufgabe der vorliegenden Erfindung ist es nun, einen Regelverstärker der eingangs genannten Art anzugeben, der eine hohe Gleichspannungs- bzw. Niederfrequenzsignal-Verstärkung und unabhängig davon eine wesentlich niedrigere Hochfrequenzsignal-Verstärkung aufweist, wobei der Regelverstärker insgesamt eine nur geringe Phasendrehung des übertragenen Signals bewirkt und für hohe Frequenzen einen sehr kleinen Innenwiderstand besitzt.

Die Aufgabe wird erfindungsgemäß dadurch gelöst, daß der Regelverstärker aus der Parallelschaltung eines Hochfrequenzverstärkers und eines Niederfrequenzverstärkers besteht.

Zweckmäßige Ausführungen der Erfindung gehen aus den Unteransprüchen hervor.

Durch die Trennung der Hochfrequenzsignal-Verstärkung von der Niederfrequenzsignal-Verstärkung ist es möglich, beide Signale für sich in einem gewünschten optimalen Maß zu verstärken. Zudem läßt sich der Hochfrequenz-Verstärker unabhängig vom Niederfrequenz-Verstärker einstufig aufbauen. Die Forderung nach hoher Stabilität und geringer Phasendrehung läßt sich bei einem solchen einstufigen Hochfrequenz-Verstärker mit sehr einfachen Mitteln realisieren.

Anhand eines in der Zeichnung dargestellten Ausführungsbeispiels wird nun die Erfindung näher erläutert. Es zeigen:

Fig. 1 einen Phasenregelkreis mit einem Regelverstärker,
Fig. 2 ein Blockschaltbild des Regelverstärkers nach der Erfindung und
Fig. 3 eine konkrete Realisierung dieses Regelverstärkers.

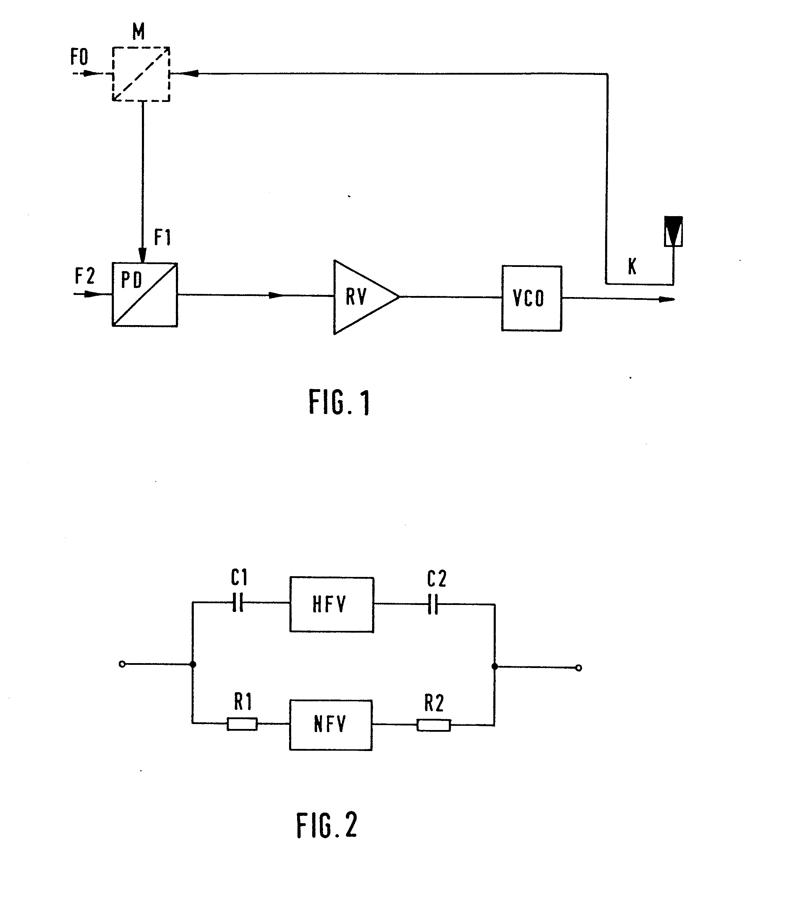

In der Fig. 1 ist ein Phasenregelkreis (PLL) dargestellt, wie er üblicherweise zur Verstärkung oder Demodulation eines frequenzmodulierten Signals eingesetzt wird. Am Ausgang eines spannungsgesteuerten Oszillators VCO wird mittels eines Kopplers K ein Signalanteil abgezweigt und auf einen Phasendiskriminator PD geführt. Dieser Signalanteil F1 wird in dem Phasendiskriminator mit dem frequenzmodulierten Referenzsignal F2 phasenmäßig verglichen. Aus dem Phasenvergleich resultiert am Ausgang des Phasendiskriminators PD eine Gleichspannung, die der mittleren Frequenzablage des spannungsgesteuerten Oszillators VCO vom Referenzsignal F2 proportional ist, und eine Wechselspannung, die der Modulation des Referenzsignals entspricht. Dieses Ausgangssignal des Phasendiskriminators wird auf einen Regelverstärker RV gegeben, der den VCO nachsteuert.

Das Ausgangssignals des VCO kann, bevor es zum Phasendiskriminator gelangt, noch mit einem Signal FO über einen Mischer M (strichliert gezeichnet) in seiner Frequenz umgesetzt werden. Somit läßt sich ein Sender realisieren, der in bekannter Weise nach dem Überlagerungsprinzip arbeitet.

Die Fig. 2 zeigt ein Prinzipschaltbild des erfindungsgemäßen Regelverstärkers. Und zwar besteht der Regelverstärker aus der Parallelschaltung eines Hochfrequenzverstärkers HFV und eines Niederfrequenzverstärkers NFV. Der Niederfrequenzverstärker soll in dem Frequenzbereich von ca. 0 bis 10 kHz eine Verstärkung von 20 ... 50 dB und der Hochfrequenzverstärker in dem Frequenzbereich von ca. 0,5 bis 100 MHz eine Verstärkung von 3 ... 26 dB aufweisen. Zur Nachsteuerung des VCO muß also der Regelverstärker eine sehr viel größere Verstärkung des niederfrequenten Signals als des hochfrequenten Signals bewirken. Es reicht daher für die Verstärkung des Hochfrequenzsignals ein einstufiger Hochfrequenzverstärker aus.

Am Eingang und Ausgang sind beide Verstärker über Frequenzweichen, bestehend aus RC-Gliedern R1 C1 und R2 C2, zusammengeschaltet. Die Weichen bestimmen den Übergangsbereich zwischen den Verstärkern und stellen die Verbindung zu der vorhergehenden (PD) und der nachfolgenden (VCO) Baugruppe her.

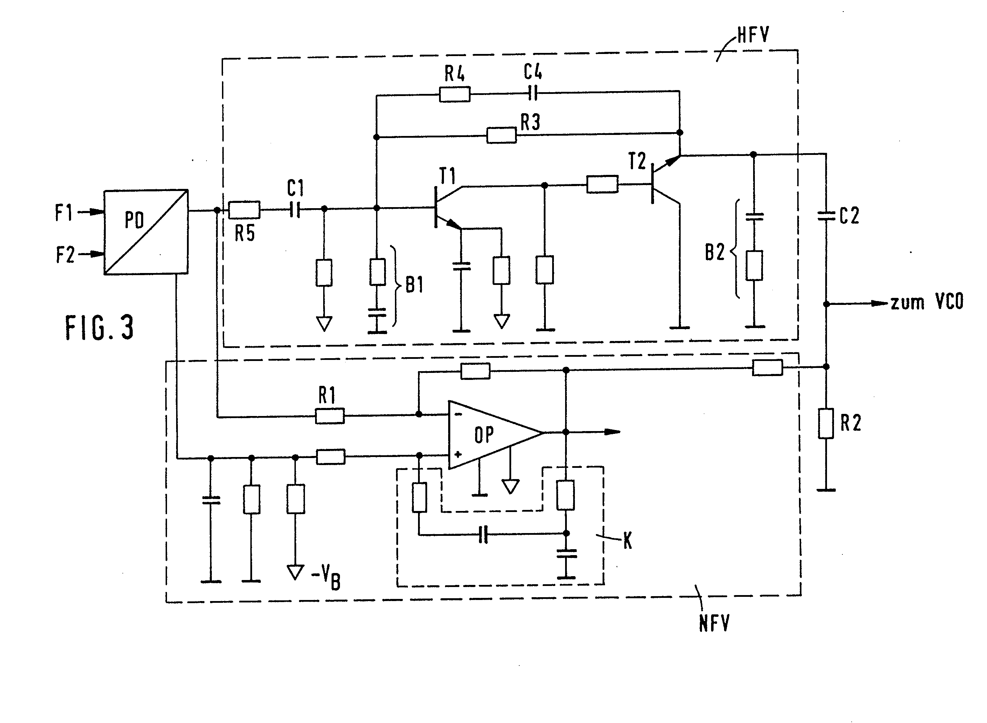

Eine konkrete Ausführung des Regelverstärkers zeigt die Fig. 3. Die beiden Verstärker HFV und NFV werden gemeinsam mit dem vorgeschalteten Phasendiskriminator PD von der Betriebsspannung $V_B$ gespeist. Wie bereits oben erwähnt, sind der Hochfrequenz- und der Niederfrequenzverstärker über die RC-Kombinationen R1 C1 und R2 C2 am Eingang und Ausgang zusammengeschaltet.

Der einstufige, gegengekoppelte Hochfrequenz-Verstärker HFV enthält einen Mikrowellentransistor T1 mit einem Emitterfolger T2 zur Stromverstärkung. Beide Transistoren verursachen eine nur sehr geringe Phasendrehung. Ein typischer Wert hierfür ist 0,36°/MHz, der einer Signallaufzeit von $\approx$ 1 µs entspricht.

Die Transistoren T1 und T2 sind von einem Rückkopplungszweig mit den Widerständen R3, R4 und der Kapazität C4 überbrückt. Dieser Rückkopplungszweig im Zusammenhang mit dem im Basiszweig des Transistors T1 liegenden Widerstand R5 bewirkt in Abhängigkeit von der Wahl und Dimensionierung der Bauelemente eine Verbesserung des Übertragungsverhaltens des Verstärkers in einem gewünschten Frequenzbereich.

Es empfiehlt sich, um parasitäre Streureaktanzen, die zu Instabilitäten des Hochfrequenzverstärkers führen können, zu vermeiden, ein konzentrierter Aufbau der Schaltung, z.B. in Dickschichttechnik.

Wie die Fig. 3 zeigt, sind parallel zum Ein- und Ausgang des Hochfrequenzverstärkers noch zur Bedämpfung evtl. auftretender Instabilitäten sogenannte Bodeglieder B1 und B2 (RC-Netzwerke) geschaltet.

Als Niederfrequenzverstärker NFV ist ein Operationsverstärker OP eingesetzt. Auf seine an sich bekannte äußere Beschaltung sei hier nicht näher eingegangen.

Es sei noch erwähnt, daß das Ausgangssignal des Operationsverstärkers herangezogen werden kann zur Überwachung, ob die Schleife des PLL geschlossen ist oder nicht.

Phasenregelschleifen, bei denen der Haltebereich wesentlich größer ist als der Übertragungsbereich, können üblicherweise nicht mehr selbständig synchronisieren, wenn die Synchronität einmal verloren gegangen ist (z.B. beim Einschalten). Um den Synchronisierungsvorgang einzuleiten, gibt es folgende Möglichkeit. Die geschlossene Schleife des PLL wirkt auf den Regelverstärker wie eine zusätzliche Gegenkopplung, so daß die Verstärkung der geschlossenen Schleife 1 ist. Führt man nun die Ausgangsspannung des Regelverstärkers über ein geeignetes RC-Netzwerk K (vgl. Fig. 3) auf den nicht invertierenden Eingang des Operationsverstärkers zurück, dann wirkt der Regelverstärker bei offener Regelschleife als RC-Oszillator (- Wien-Generator), dessen Ausgangssignal den VCO in seinem gesamten Nachstimmbereich durchsteuert, bis Synchronität erreicht wird.

---------------------------

Licentia Patent-Verwaltungs-GmbH     Z13 PTL-BK/Th/ma
Theodor-Stern-Kai 1                   BK 81/93
D-6000 Frankfurt 70


Patentansprüche


1. Regelverstärker, der innerhalb eines Phasenregelkreises zwischen den Phasendetektor und den spannungsgesteuerten Oszillator geschaltet ist, dadurch gekennzeichnet, daß der Regelverstärker (RV) aus der Parallelschaltung eines Hochfrequenzverstärkers (HFV) und eines Niederfrequenzverstärkers (NFV) besteht.


2. Regelverstärker nach Anspruch 1, dadurch gekennzeichnet, daß der Hochfrequenzverstärker und der Niederfrequenzverstärker am Eingang und am Ausgang jeweils über eine Frequenzweiche, bestehend aus einer RC-Kombination (R1C1, R2C2) zusammengeschaltet sind.


3. Regelverstärker nach Anspruch 1, dadurch gekennzeichnet, daß der Hochfrequenzverstärker (HFV) eine Transistorstufe (T1) mit einem nachgeschalteten Emitterfolger (T2) besitzt und daß vom Ausgang des Emitterfolgers auf den Eingang des Verstärkers ein Rückkopplungszweig mit einem RC-Netzwerk (R3, R4, C4) geschaltet ist zur Beeinflussung des Verstärker-Übertragungsverhaltens in einem gewünschten Frequenzbereich.

4. Regelverstärker nach Anspruch 1, <u>dadurch gekennzeichnet,</u> daß zur Bedämpfung von eventuell auftretenden Instabilitäten am Eingang und am Ausgang des Hochfrequenzverstärkers (HFV) Bodeglieder (B1, B2) geschaltet sind.

FIG. 1

FIG. 2

FIG.3

HFV

R4    C4

R3

T1    T2

F1

F2

PD

R5    C1

B1

B2

C2

→ zum VCO

R1

OP

K

R2

−V_B

NFV

2/2

0073885